(19) Europäisches Patentamt
European Patent Office
Office européen des brevets

(11) **EP 1 215 679 B1**

(12) **EUROPEAN PATENT SPECIFICATION**

(45) Date of publication and mention
of the grant of the patent:
**03.03.2004 Bulletin 2004/10**

(51) Int Cl.⁷: **G11C 11/56**

(21) Application number: **01129768.6**

(22) Date of filing: **13.12.2001**

(54) **Programming method for a multilevel memory cell**

Programmierverfahren für eine Mehrpegelspeicherzelle

Méthode de programmation pour une cellule mémoire à plusieurs niveaux

(84) Designated Contracting States:
**DE FR GB IT**

(30) Priority: **15.12.2000 EP 00830827**

(43) Date of publication of application:
**19.06.2002 Bulletin 2002/25**

(73) Proprietor: **STMicroelectronics S.r.l.**
**20041 Agrate Brianza (Milano) (IT)**

(72) Inventors:
• **De Sandre, Guido**
**20047 Brugherio (Milano) (IT)**
• **Pasotti, Marco**
**27028 S. Martino Sicc. (Pavia) (IT)**
• **Rolandi, Pier Luigi**
**15059 Monleale (Alessandria) (IT)**
• **Guaitini, Giovani**
**20060 Trecella (Milano) (IT)**
• **Iezzi, David**
**23875 Osnago (Como) (IT)**
• **Poles, Marco**
**25016 Ghedi (Brescia) (IT)**

(74) Representative: **Ferreccio, Rinaldo**
**c/o Botti & Ferrari S.r.l.,**
**Via Locatelli, 5**
**20124 Milano (IT)**

(56) References cited:
**US-A- 5 936 884**          **US-A- 5 999 446**
**US-A- 6 064 597**

EP 1 215 679 B1

**Description**

<u>Field of Application</u>

This invention relates to a programming method for a multilevel memory cell able to store a plurality of bits in a plurality of levels.

The invention further relates to a multilevel memory device of the type comprising a plurality of multilevel memory cells organised into sectors, the sectors being themselves split into a plurality of data units wherein a data updating operation is performed in parallel.

The invention relates, particularly but not exclusively, to a Flash memory device, and the following description is made with reference to this application field with the only aim of simplifying its exposition.

<u>Prior Art</u>

As it is well known in the field of Flash memories, the multilevel technique is widely accepted at present as a means to increase data density, with an equal physical density of the memory cells.

Known are in fact multilevel memory devices which can store plural logic values in a single memory cell. These devices are made in the form of integrated electronic circuits, which have achieved a sufficient degree of reliability to grant large scale production for several technical and commercial applications.

The market of semiconductor integrated electronic devices is showing great interest in multilevel memory devices because they afford information storage densities which are at least twice higher than those of two-level memory devices, either with the same technology and circuit area occupation.

The operation of such multilevel memory devices will now be briefly reviewed . The different programming states of a memory cell is reflected in a different value of its threshold voltage Vth.

Of course, in the instance of a two-level cell, there would be only two values, corresponding to a logic 0 and a logic 1 state. In this case, the amount of information that can be stored results equal to one bit per cell.

On the other hand, a multilevel memory cell can store a larger number of bits than one. From the electrical standpoint, this means that there may be more than two possible threshold voltage values. The amount of information that can be stored in a single multilevel cell increases according to the following relation:

$$\text{Number of bits per cell} = \log_2(\text{number of values of Vth})$$

From the physical standpoint, the ability of altering the threshold voltage Vth, and therefore to program the multilevel memory cell, is granted by the floating gate design of the transistor which realises the memory cell. The gate region is DC-isolated but can be accessed by charge injection processes of the Channel Hot Electrons and/or Fowler-Nordheim Tunneling Effect types.

When suitably controlled, these processes allow the amount of charge caught in the floating gate to be modulated, thereby allowing the effect of the latter on the threshold voltage value Vth to be changed.

The possibility of generating, in a large number of cells, a set of threshold voltage levels which can be distinguished upon reading is utilised to increase the density of the stored data.

However, the. multilevel technique has inherently the disadvantage of slowing the processes of reading and programming each cell.

Also, there are applications -- e.g. the implementation of a FAT memory for disk-on-silicon embodiments -- which require the writing of small amounts of data, usually at non-contiguous addresses, for which the programming times are significantly longer.

In these applications, data updating requires that erasing/programming cycles be executed. In view of the time taken by such operations, two major problems stand out:

- the updating time per bit becomes unacceptable whenever the amount of data to be updated is small; and

- an auxiliary memory is needed to store up data not to be updated, which data are nevertheless bound to become erased, since a whole sector would be erased at one time.

These problems make the use of current Flash memory architectures improposable.

Furthermore, power consumption is critical to such applications: all the energy used to store data which require no updating, and yet are affected by the erasing/programming process, is lost with respect to the updating operation.

Power usage is the more inefficient the smaller is the ratio between the data to be updated and the sector size.

The US Patent No. 5,936,884 granted on 10.08.1999 in the name of Hasbun et al. describes a method for performing multiple writes before erasing a memory cell, using the multilevel technique, and hence the possibility of generating a set of threshold voltage levels in a large number of Flash cells, which voltage levels can be distinguished during a reading operation.

In particular, according to this known method, M bits are stored in a first group of levels of a multilevel memory cell and M superseding bits are stored in a second group of levels of the multilevel memory cell without erasing the cell itself. A group indicator is adjusted to identify a subsequent group of levels of the multilevel memory cell.

According to the known method described in the US Patent to Hasbun et al., the levels are "superimposed", i.e. the high level of a group is made to coincide with a low level of a subsequent group.

Thus, according to such a known solution, only N-1 levels of a total number N of levels are used to perform the reprogramming without erasing operations.

Moreover, to determine the value stored in a given multilevel memory cell, it is necessary to know what the last level written was, i.e. a tracking mechanism is needed. The group indicator described in the above cited US Patent provides for such a tracking mechanism to keep track of the current level or the proper reference voltage to use.

The degree of which tracking is performed (i.e. cell by cell, block, groups of blocks or device levels) is known as the tracking resolution.

The US patent to Hasbun et al. states that a tracking mechanism implemented on a cell by cell basis might be inefficient. Moreover, when considering Flash memory devices, since all Flash cells within a block must be erased anyway, tracking might prove to be most efficient at the block or even the device level.

It should be noted that, contrary to what stated in such a known Patent, a group indicator on a block by block basis, or block indicator, increases the number of erasing executed for each cell. In fact, the bigger the block size, the greater the probability upon subsequent programming operations that the block indicator reaches the maximum value, thus requiring the sector, and hence the block, to be erased.

Even advantageous under various aspects, the above described known solution has a main drawback, connected to the tracking mechanism. In fact, the need of a tracking mechanism as a group indicator increases the complexity of the programming method for multilevel memory cells as well as of the corresponding multilevel memory device.

Summary of the Invention

The underlying technical problem of this invention is to provide a method of programming Flash memory cells, which method has structural and functional features able to simplify the programming without erasing mechanism, thereby overcoming the drawbacks with which methods of programming memory devices, according to the prior art, are beset. In particular, the present invention provides for a simplified method to perform multiple reprogramming without erasing that does not require a tracking mechanism to keep track of the current level being programmed.

The technical problem is solved by a programming method as previously indicated and defined in the characterising portion of Claim 1.

The problem is also solved by a multilevel memory device as previously indicated and defined in the characterising portion of Claim 8.

The problem is further solved by a multilevel memory device as previously indicated and defined in the characterising portion of Claim 12.

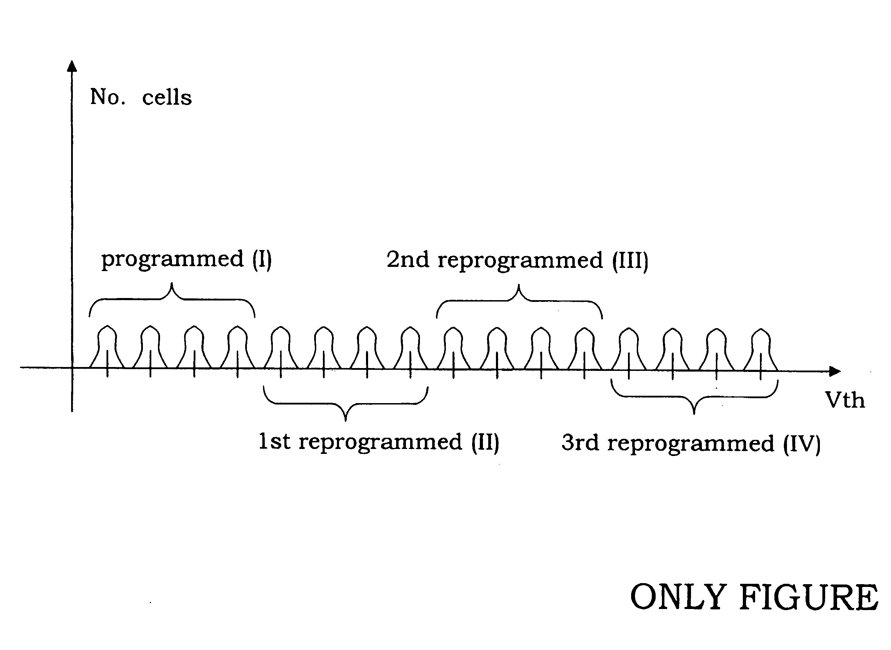

The features and advantages of the programming method and multilevel memory devices according to the invention will be apparent from the following description, of an embodiment thereof, given by way of example and not of limitation with reference to the accompanying drawing.

Brief Description of the Drawings

The only Figure schematically shows the operation of the programming method according to the invention.

Detailed Description

With reference in particular to the only Figure, it is considered a programming through sixteen levels, being the equivalent of four bits per cell.

Advantageously according to the invention, two bits of each multilevel cell are programmed using the first four levels only. This leaves out twelve free levels, which remain available for three further reprogrammings of two bits per cell.

In particular, the first four levels are used to initially program (I) the cell, the following four levels to a.first reprogramming. without erasing (II), the next four levels to a second reprogramming without erasing (III), and the last four levels to a third reprogramming without erasing (IV).

In other words, a memory device using the method according to the present invention gives up two data density bits in favour of three reprogrammings without erasing.

Advantageously according to the present invention, the information of the reprogramming state is contained directly in the threshold level of the cell itself, no tracking mechanism for the level which has been programmed being required.

]This programming method based on the multilevel technique can be extended in the manner explained here below.

Starting with a number nmax of bits per cell, and $Nmax=2^{nmax}$ of possible levels according to the multilevel technique, it is considered that n density bits are maintained, and $N_R$ is the number of reprogrammings without erasing.

This gives:

$$N_R = 2^{(nmax-n)} - 1$$

It is useful to express the number (N) of used levels in function of the number (n) of density bits and the number ($N_R$) of reprogrammings without erasing.

Table 1 below shows the levels required by the above reprogramming without erasing technique, in function of n and $N_R$.

## Table I

| $n/N_R$ | 0 | 1 | 2 | 3 | 4 | 5 | 6 | 7 |
|---------|---|---|---|---|---|---|---|---|
| 1 | 2 | 4 | 6 | 8 | 10 | 12 | 14 | 16 |
| 2 | 4 | 8 | 12 | 16 | 20 | 24 | | |
| 3 | 8 | 16 | 24 | | | | | |
| 4 | 16 | 32 | | | | | | |

The relation between the total number (N) of levels and the independent parameters n and $N_R$ is:

$$N = 2^n(N_R + 1)$$

In a preferred embodiment of the inventions m levels are used to store bit values, where m can be equal or different from $2^n$. Having set independently the number of reprogrammings $N_R$, the total number N of available levels of the multilevel cell is:

$$N = m(N_R + 1)$$

Therefore, in such a preferred embodiment, the total number of available levels N is split into ($N_R + 1$) groups, or sets, of m levels.

It should be noted here that the implementation of this reprogramming without erasing method using multilevel cells doesn't force any constraints on the layout of the memory sector containing said cells.

In particular, once the sector size is set, a unit of minimal size, and on which the data updating operation will be effected in parallel, may be defined as any integer number of cells (which is contained a whole number of times in that sector), down to only one cell, without any waste of area.

Before each programming, every cell in the unit is read, and the information contained in it allows a decision to be made as to the level at which the cells is to be reprogrammed, depending on the number of reprogrammings already effected, as schematically shown in the only Figure.

It is also evident that, as the decision can be taken on a cell by cell basis, not all the cells need to be reprogrammed to the subsequent group of levels. In particular, a reprogramming step should be applied only to the cells whose threshold voltage value should be increased in order to store a digital value, which is greater than the previously stored value.

To better comprise the method according to the present invention, let's consider, by way of a non-limitative example, two bits per cell over 16 levels, and a cell which is programmed to a "1" value, for the first time, that is on group (I).

In order to program a "2" value it is sufficient to raise the threshold voltage value Vth of the cell to the next level. On the contrary, in order to program a "0" value it is necessary to raise the threshold voltage value Vth up to the first level of group (II).

In other word, the programming method according to the invention provides for a reprogramming of the multilevel cell by maintaining its threshold voltage value within a same set of m levels, whenever the value to be reprogrammed corresponds to a higher level than the previously stored one.

So, advantageously according to the present invention, the programming method comprises a step of reading the digital value contained in the multilevel memory cell before deciding to what level it has to be reprogrammed. In particular, the state of the multilevel cell is deduced by its threshold voltage value, thus determining if it is in the erased, programmed or reprogrammed state, as well as the number of reprogramming steps already performed on such a cell.

In case that all possible reprogrammings have been effected, a system is activated which allows the following operations to be carried out, while stopping the use of the memory for the shortest possible time:

-    restoring the sector to its original condition (erasing); and

-    restoring the data according to the last-effected updating (first programming).

Thus, unlike the prior art, the sector erasing and updating phase can only take place after all possible ($N_R$) reprogrammings are made, resulting in significantly reduced time and power consumption for the memory device considered.

To make this programming method more clearly understood, a possible embodiment of a suitable multilevel memory device to implement the proposed programming method will now be described for the instance of n=2 and $N_R$=3, that is for two-bit programmings and three possible reprogrammings without erasing.

In particular, the instance will be considered of two sectors, namely a sector S and a sector C, being used to store up the same data, with sector C being an updated copy of sector S. Thus, sector S will be programmed and/or reprogrammed first.

Assume data units UD to be contained in these sectors S and C, which units comprise 16 cells for the data.

Directly after the erase phase, the threshold voltage values (VthDATI) of those memory cells which contain the data of the sectors S and C are all at the 0 level, i.e. the first of the sixteen possible levels.

After the initial programming, the memory cells containing the data will have thresholds in the level range of 0 to 3, to indicate that no reprogrammings have been made.

During the next three reprogrammings, the threshold levels of the memory cells which contain the data will have, in the worst case, the values shown in Table II below.

Table II

| Number of reprogrammings | VthDATI |
| --- | --- |
| 1 | 4-7 |
| 2 | 8-11 |
| 3 | 12-15 |

Of course any cell can have a threshold voltage value lower than the above worst case values if the digital value to be reprogrammed is greater than the previously stored one, as discussed above.

In general, the value of the threshold levels will follow the Table IIb below

Table IIb

| Number of reprogrammings | VthDATI |
|---|---|
| 1 | $(2^n) - (2*2^n-1)$ |
| 2 | $(2*2^n) - (3*2^n-1)$ |
| 3 | $(3*2^n) - (4*2^n-1)$ |

where,

VthDATI is a threshold voltage value of data cells of a data unit UD in the sectors S and C; .and

n is the data bit density.

Assuming the memory device yields a 4 bit number for such a threshold voltage value, the first two bits indicate the group of levels (I, II, III, IV) while the last two bits indicate the stored value (0, 1, 2, 3).

The state of a cell in a data unit UD can be obtained by taking into consideration the threshold voltage values of the data-containing cells, as shown in Table III below.

Table III

| VthDATI | STATE |
|---|---|
| All 0 | Erased |
| 0-3 | Programmed |
| 4-7 | Reprogrammed I |
| 8-1 | Reprogrammed II |
| 12-15 | Reprogrammed III |

By reading the multilevel cell, and thus its threshold voltage value VthDATI, it is possible' to deduce if such a cell is in the erased, programmed and reprogrammed (I, II and II) state.

Furthermore, a pair of counters is associated with either sectors S, C, namely: a programmed-unit counter (CUP) and an exhausted-unit counter (CUE). The former will count up each time that the first programming is effected on a data unit UD. The latter will count up as the threshold voltage (VthDATI) of any cell of a data unit UD is brought to level 12 or higher.

When any cell in a data unit UD of sector S has already undergone three reprogrammings and needs a further updating, sector C is brought into play.

A second phase is then started wherein all reprogrammings are made in the new sector.

As previously explained, the cells in the data unit UD in sector C are first read. For first programming, the value of the threshold voltage (VthDATI) of at least one cell in the corresponding data unit of sector S is brought to level 12 (if not already there). Accordingly, the exhausted-unit counter CUE counts up, while the data are programmed in sector C. For reprogramming, only sector C is acted upon.

In this second phase, the programmed unit counter CUP of sector S can no longer count up. As the exhausted-unit counter CUE of sector S reaches the same count as the programmed-unit counter CUP, sector S will no longer contain updated information, and its erasing can be started as a background operation with respect to the use processes the memory device containing sector S.

At this stage, sectors S and C reverse their roles, and the process goes back to the initial phase.

A data unit UD of sector C might be actually in need of the fourth reprogramming before sector S has been erased.

This event corresponds to a locked condition. Therefore, it becomes necessary to stop normal operation of the memory and update the contents of sector C by copying, from sector S, those data units UD which are still valid, and then erase sector S in order to program therein the data which could not be reprogrammed in sector C.

It is only at this point that the roles of sectors S and C can be reversed, and normal operation of the memory resumed as in the second programming phase.

The above locked condition may also occur after the erasing phase has already started. In this case, all that is required is to wait for the erasing to end in sector S, and to program the new data in sector S.

The proposed example, based on the use of two counters per sector and two sectors, is merely illustrative of the reprogramming without erasing method and in no way limitative of the invention applicability.

With reference to the known methods, the method according to the present invention allows a larger number of bits to be stored per unit area, especially where small-size data units UD are provided.

So, more levels have to be used for each reprogramming, but the information in the reprogramming state is contained directly in the threshold level of the cell itself, no tracking mechanism of the used level being required.

**Claims**

1. A programming method for a multilevel memory cell able to store a plurality of bits in a plurality of N levels, comprising the phases of:

   - initially programming a threshold value VthDATI of said memory cell to a first value out of a first set (I) of m levels between 0 and m-1, wherein m is a submultiple of said plurality of N levels of said multilevel cell;

   - reprogramming without erasing said memory cell to another value out of a second set (II) of m levels between m and 2m-1, which is containing the same number m of levels as said first set;

   - reiterating the reprogramming without an erasing phase $N_R$-1 times (III, IV, ...) until the N levels of said multilevel cell are all exhausted

   **characterised in that** it further comprises a step of reading the threshold voltage value VthDATI of said multilevel cell before deciding deduced from its threshold voltage value whether the cell has to be reprogrammed to the erased state, programmed state or the reprogrammed state.

2. A programming method according to Claim 1, **characterised in that** said total number of N levels is a function of said number of m levels in each of said sets available for reprogramming and said number $N_R$ of reprogrammings without erasing by the following relation:

$$N = m(N_R + 1)$$

3. A programming method according to Claim 1, **characterised in that** said total number of N levels is a function of said plurality of n bits stored in the multilevel cell and the number $N_R$ of reprogrammings without erasing by the following relation:

$$N = 2^n(N_R + 1)$$

4. A programming method according to Claim 1, **characterised in that** it further comprises a step of reprogramming a multilevel cell by maintaining its threshold voltage value VthDATI within a same of said set of m levels, whenever the value to be reprogrammed corresponds to a higher level than the previously stored one.

5. A programming method according to Claim 1, **characterised in that** it further comprises a further phase of restoring said multilevel memory cell to an initial condition.

6. A programming method according to Claim 5, **characterised in that** said phase of restoring to an initial condition comprises a phase of erasing a memory sector where said cell is located.

7. A programming method according to Claim 5, **characterised in that** said phase of restoring to an initial condition comprises a data restoring phase consistent with said initial programming (I).

8. A multilevel memory device of the type comprising a memory array including a plurality of multilevel memory cells organised into sectors, the sectors being themselves split into a plurality of data units UD, a data updating operation being performed in parallel within said plurality of data units, **characterised in that** said memory comprises means providing that said data units UD are programmed by a programming method as claimed in any of the preceding claims, and that said maximum number of possible reprogrammings is univocally fixed by the threshold level of said cell.

9. A multilevel memory device according to Claim 8, **characterised in that** it comprises at least a first sector S, and a second sector C which is an updated copy of the first sector, both sectors being organised into data units UD, and **in that** said initial programming phase (I) relates said first sector S.

10. A multilevel memory device according to Claim 9, **characterised in that** said reprogramming phases modify threshold voltage values of said memory cells according, in the worst case, to the following table:

| Number of reprogrammings | VthDATI |
|---|---|
| 1 | $(2^n) - (2*2^n-1)$ |
| 2 | $(2*2^n) - (3*2^n-1)$ |
| 3 | $(3*2^n) - (4*2^n-1)$ |

where,

VthDATI is a threshold voltage value of data cells of a data unit in said sectors; .and

n is a data bit density

11. A multilevel memory device of a type comprising a memory array including a plurality of multilevel memory cells organised into sectors, the sectors being themselves split into a plurality of data units UD, a data updating operation being performed in parallel within said plurality of data units UD, **characterised in that** it comprises at least a first sector S and a second sector C which is an updated copy of the first one, wherein the memory comprises means providing that both sectors being organised into data units UD programmed by a programming method as claimed in any of the preceding claims, and that said sectors are associated to a first programmed-unit counter CUP and a second exhausted-unit counter CUE, said first counter counting up each time that a first programming is effected in a data unit UD of the associated sector, and the second counter CUE counting up upon any cell of a data unit UD of the associated sector reaching the maximum number $N_R$ of possible reprogrammings.

12. A multilevel memory device according to Claim 11, **characterised in that** said programming/reprogramming phases are carried out in said second sector C, starting from the moment that a reprogramming phase affects a data unit UD of said first sector S which has reached the maximum number $N_R$ of possible reprogrammings, and conversely, **in that** said programming/ reprogramming phases are carried out in said first sector S, starting from when, having been the roles of said first and second sectors exchanged after erasing said first sector S, a reprogramming phase affects a data unit UD of said second, sector C which has reached the maximum number $N_R$ of possible reprogrammings.

13. A multilevel memory device according to Claim 11, **characterised in that** it provides a phase of erasing one sector upon said second exhausted-unit counter CUE associated with said sector reaching the same count as said first programmed-unit counter CUP.

14. A multilevel memory device according to Claim 13, **characterised in that** it provides a phase of locking out the normal usage of the memory device to update the contents of said second sector C by copying those data units UD which are still valid from said first sector S, followed by a phase of erasing said first sector S, and a phase of programming data in said first sector S, said locking phase being applied whenever a data unit UDof said second sector C needs a larger number of reprogrammings than said maximum number before said phase of erasing said first sector S.

**Patentansprüche**

1. Programmierverfahren für eine Multipegelspeicherzelle, die imstande ist, mehrere Bits in mehreren N Pegeln zu speichern, umfassend die folgenden Phasen:

- zunächst Programmieren eines Schwellwerts VthDATI der Speicherzelle auf einen ersten Wert aus einem ersten Satz (I) von m Pegeln zwischen 0 und m-1, wobei m ein ohne Rest aufgehender Teiler der mehreren N Pegel der Multipegelzelle ist;

- Umprogrammieren der Speicherzelle ohne Löschen auf einen anderen Wert aus einem zweiten Satz (II) von m Pegeln zwischen m und 2m-1, der dieselbe Anzahl m Pegel wie der erste Satz enthält;

- Wiederholen des Umprogrammierens ohne Löschphase $N_R$-1 Male (III, IV, ...), bis die N Pegel der Multipegelzelle alle ausgeschöpft sind,

**dadurch gekennzeichnet, dass** es weiterhin den Schritt des Lesens des Schwellspannungswerts VthDATI der Multipegelzelle umfasst, bevor es in Ableitung von seinem Schwellspannungswert feststellt, ob die Zelle in den gelöschten Zustand, den programmierten Zustand oder den umprogrammierten Zustand umprogrammiert werden muss.

2. Programmierverfahren nach Anspruch 1, **dadurch gekennzeichnet, dass** die Gesamtzahl der N Pegel eine Funktion der Anzahl von m Pegeln in jedem der Sätze, die zur Umprogrammierung zur Verfügung stehen, und der Anzahl $N_R$ von Umprogrammierungen ohne Löschen durch die folgende Beziehung

$$N = m(N_R + 1)$$

darstellt.

3. Programmierverfahren nach Anspruch 1, **dadurch gekennzeichnet, dass** die Gesamtzahl der N Pegel eine Funktion der mehreren n Bits, die in der Multipegelzelle gespeichert sind, und der Anzahl $N_R$ von Umprogrammierungen ohne Löschen durch die folgende Beziehung

$$N = 2^n(N_R + 1)$$

darstellt.

4. Programmierverfahren nach Anspruch 1, **dadurch gekennzeichnet, dass** es weiterhin einen Schritt des Umprogrammierens einer Multipegelzelle durch Aufrechterhaltung ihres Schwellspannungswerts VthDATI innerhalb desselben Satzes von m Pegeln umfasst, wann immer der umzuprogrammierende Wert einem höheren Pegel als dem bisher gespeicherten entspricht.

5. Programmierverfahren nach Anspruch 1, **dadurch gekennzeichnet, dass** es weiterhin eine weitere Phase zur Rückversetzung der Multipegelspeicherzelle in einen Ausgangszustand umfasst.

6. Programmierverfahren nach Anspruch 5, **dadurch gekennzeichnet, dass** die Phase der Rückversetzung in einen Ausgangszustand eine Phase der Löschung eines Speichersektors, in dem die Zelle lokalisiert ist, umfasst.

7. Programmierverfahren nach Anspruch 5, **dadurch gekennzeichnet, dass** die Phase der Rückversetzung in einen Ausgangszustand eine Datenwiederherstellungsphase, die mit einer Ausgangsprogrammierung (I) konsistent ist, umfasst.

8. Multipegelspeichervorrichtung des Typs, der ein Speicherfeld einschließlich mehrerer in Sektoren organisierter Multipegelspeicherzellen umfasst, wobei die Sektoren selbst in mehrere Dateneinheiten UD gespalten sind und eine Datenaktualisierung parallel innerhalb der mehreren Dateneinheiten durchgeführt wird, **dadurch gekennzeichnet, dass** der Speicher Mittel umfasst, welche vorsehen, dass die Dateneinheiten UD durch ein Programmierungsverfahren, wie es in irgendeinem der vorhergehenden Ansprüche beansprucht wird, programmiert werden und dass die maximale Anzahl möglicher Umprogrammierungen durch den Schwellenpegel der Zelle eindeutig festgelegt wird.

9. Multipegelspeichervorrichtung nach Anspruch 8, **dadurch gekennzeichnet, dass** sie wenigstens einen ersten Sektor S und einen zweiten Sektor C umfasst, der eine aktualisierte Kopie des ersten Sektors darstellt, wobei beide Sektoren in Dateneinheiten UD organisiert sind und dass sich die Ausgangsprogrammierungsphase (I) auf den ersten Sektor S bezieht.

10. Multipegelspeichervorrichtung nach Anspruch 9, **dadurch gekennzeichnet, dass** die Umprogrammierungsphasen Schwellspannungswerte der Speicherzellen modifizieren, im schlechtesten Fall gemäß der folgenden Tabelle:

| Anzahl der Umprogrammierungen | VthDATI |
|---|---|
| 1 | $(2^n) - (2*2^n-1)$ |
| 2 | $(2*2^n) - (3*2^n-1)$ |
| 3 | $(3*2^n) - (4*2^n-1)$ |

worin

VthDATI für einen Schwellspannungswert von Datenzellen einer Dateneinheit in den Sektoren steht; und

n für eine Datenbitdichte steht.

11. Multipegelspeichervorrichtung eines Typs, der ein Speicherfeld mit mehreren in Sektoren organisierten Multipegelspeicherzellen umfasst, wobei die Sektoren selbst in mehrere Dateneinheiten UD gespalten sind und eine Datenaktualisierung parallel innerhalb der mehreren Dateneinheiten durchgeführt wird, **dadurch gekennzeichnet, dass** sie wenigstens einen ersten Sektor S und einen zweiten Sektor C, der eine aktualisierte Kopie des ersteren ist, wobei der Speicher Mittel umfasst, welche vorsehen, dass beide Sektoren in Dateneinheiten UD organisiert werden, die durch ein Programmierungsverfahren, wie es in irgendeinem der vorhergehenden Ansprüche beansprucht wird, programmiert werden und dass die Sektoren mit einem ersten Zähler CUP zum Zählen der programmierten Einheiten und einem zweiten Zähler CUE zum Zählen der ausgeschöpften Einheiten verknüpft sind, wobei der erste Zähler jedes Mal, wenn eine erste Programmierung in einer Dateneinheit UD des verknüpften Sektors ausgeführt wird, vorwärts zählt und der zweite Zähler CUE jedes Mal, wenn irgendeine Zelle einer Dateneinheit UD des verknüpften Sektors die maximale Anzahl $N_R$ möglicher Umprogrammierungen erreicht, vorwärts zählt.

12. Multipegelspeichervorrichtung nach Anspruch 11, **dadurch gekennzeichnet, dass** die Programmierungs/Umprogrammierungsphasen im zweiten Sektor C erfolgen und in dem Augenblick beginnen, in dem eine Umprogrammierungsphase eine Dateneinheit UD des ersten Sektors S beeinflusst, die die maximale Anzahl $N_R$ möglicher Umprogrammierungen erreicht hat, und umgekehrt dadurch, dass die Programmierungs-/Umprogrammierungsphasen in dem ersten Sektor S erfolgen und dann beginnen, wenn, nachdem die Rollen des ersten und des zweiten Sektors nach dem Löschen des ersten Sektors S vertauscht wurden, eine Umprogrammierungsphase eine Dateneinheit UD des zweiten Sektors C beeinflusst, die die maximale Anzahl $N_R$ möglicher Umprogrammierungen erreicht hat.

13. Multipegelspeichervorrichtung nach Anspruch 11, **dadurch gekennzeichnet, dass** sie eine Phase des Löschens eines Sektors vorsieht, wenn der zweite Zähler CUE zum Zählen der ausgeschöpften Einheiten, der mit dem Sektor verknüpft ist, denselben Zählerstand wie der erste Zähler CUP zum Zählen der programmierten Einheiten erreicht.

14. Multipegelspeichervorrichtung nach Anspruch 13, **dadurch gekennzeichnet, dass** sie eine Phase des Sperrens des normalen Gebrauchs der Speichervorrichtung vorsieht, um den Inhalt des zweiten Sektors C durch Kopieren jener Dateneinheiten UD, die vom ersten Sektor S her noch gültig sind, zu aktualisieren, gefolgt von einer Phase des Löschens des ersten Sektors S und einer Phase des Programmierens von Daten in den ersten Sektor S, wobei die Sperrphase jedes Mal angewendet wird, wenn eine Dateneinheit UD des zweiten Sektors C eine größere Anzahl Umprogrammierungen als die maximale Anzahl vor der Phase des Löschens des ersten Sektors S benötigt.

**Revendications**

1. Procédé de programmation pour une cellule de mémoire multiniveau pour stocker une pluralité de bits dans une pluralité de N niveaux, comprenant les phases consistant à :

programmer initialement une valeur de seuil VthDATI de ladite cellule de mémoire à une première valeur d'un premier ensemble (I) de m niveaux entre 0 et m-1, où m est un sous-multiple de ladite pluralité de N niveaux de ladite cellule multiniveau ;

reprogrammer sans effacer ladite cellule de mémoire à une autre valeur d'un second ensemble (II) de m niveaux entre m et 2m-1, qui contient le même nombre m de niveaux que ledit premier ensemble ;
réitérer la programmation sans une phase d'effacement $N_{R-1}$ fois (III, IV, ...) jusqu'à ce que les N niveaux de ladite cellule multiniveau soient tous purgés ;

**caractérisé en ce qu'**il comprend, de plus, une étape de lecture de la valeur de tension de seuil VthDATI de ladite cellule multiniveau avant de décider, à partir de sa valeur de tension de seuil, si la cellule doit être reprogrammée à l'état effacé, l'état programmé ou l'état reprogrammé.

2. Procédé de programmation selon la revendication 1, **caractérisé en ce que** ledit nombre total de N niveaux est une fonction dudit nombre de m niveaux dans chacun desdits ensembles disponibles pour reprogrammation et dudit nombre $N_R$ de reprogrammations sans effacement selon la relation suivante :

$$N = m(N_R + 1)$$

3. Procédé de programmation selon la revendication 1, **caractérisé en ce que** ledit nombre total de N niveaux est une fonction de ladite pluralité de n bits stockés dans la cellule multiniveau et du nombre $N_R$ de reprogrammations sans effacement selon la relation suivante :

$$N = 2^n(N_R + 1)$$

4. Procédé de programmation selon la revendication 1, **caractérisé en ce qu'**il comprend, de plus, l'étape de reprogrammation d'une cellule multiniveau en maintenant sa valeur de tension de seuil VthDATI à celle dudit ensemble de m niveaux, lorsque la valeur à reprogrammer correspond à un niveau supérieur à celui précédemment stocké.

5. Procédé de programmation selon la revendication 1, **caractérisé en ce qu'**il comprend, de plus, une phase supplémentaire de restauration de ladite cellule multiniveau à un état initial.

6. Procédé de programmation selon la revendication 5, **caractérisé en ce que** ladite phase de restauration à un état initial comprend une phase d'effacement d'un secteur de mémoire où ladite cellule est positionnée.

7. Procédé de programmation selon la revendication 5, **caractérisé en ce que** ladite phase de restauration à un état initial comprend une phase de restauration de données cohérente avec ladite programmation initiale (I).

8. Dispositif de mémoire multiniveau du type comprenant une matrice de mémoire, comprenant une pluralité de cellules de mémoire multiniveau organisées en secteurs, les secteurs étant eux-mêmes divisés en une pluralité d'unités de données UD, une opération de mise à jour de données étant effectuée en parallèle dans ladite pluralité d'unités de données, **caractérisé en ce que** ladite mémoire comprend des moyens permettant que lesdites unités de données UD soient programmées selon un procédé de programmation selon l'une quelconque des revendications précédentes et que ledit nombre maximal de reprogrammations possibles soit fixé de manière univoque par le niveau de seuil de ladite cellule.

9. Dispositif de mémoire multiniveau selon la revendication 8, **caractérisé en ce qu'**il comprend au moins un premier secteur S et un second secteur C qui est une copie mise à jour du premier secteur, les deux secteurs étant organisés en unités de données UD et **en ce que** ladite phase de programmation initiale (I) concerne ledit premier secteur S.

10. Dispositif de mémoire multiniveau selon la revendication 9, **caractérisé en ce que** lesdites phases de reprogrammation modifient les valeurs de tension de seuil desdites cellules de mémoire conformément, dans le pire des cas, au tableau suivant :

| Nombre de reprogrammations | VthDATI |
|---|---|
| 1 | $(2^n) - (2*2^n-1)$ |
| 2 | $(2*2^n) - (3*2^n-1)$ |
| 3 | $(3*2^n) - (4*2^n-1)$ |

où,

VthDATI est une valeur de tension de seuil de cellules de données d'une unité de données dans lesdits secteurs ; et

n est une densité de bits de données.

11. Dispositif de mémoire multiniveau d'un type comprenant une matrice de mémoire, comprenant une pluralité de cellules de mémoire multiniveau organisées en secteurs, les secteurs étant eux-mêmes divisés en une pluralité d'unités de données UD, une opération de mise à jour de données étant effectuée en parallèle dans ladite pluralité d'unités de données UD, **caractérisé en ce qu'**il comprend au moins un premier secteur S et un second secteur C, qui est une copie mise à jour du premier, dans lequel la mémoire comprend des moyens permettant que les deux secteurs soient organisés en unités de données UD programmées selon un procédé de programmation selon l'une quelconque des revendications précédentes, et que lesdits secteurs sont associés à un premier compteur d'unités programmées CUP et un second compteur d'unités purgées CUE, ledit premier compteur comptant dans l'ordre croissant chaque fois qu'une première programmation est effectuée dans une unité de données UD du secteur associé et le second compteur CUE comptant dans l'ordre croissant lorsqu'une cellule quelconque d'une unité de données UD du secteur associé atteint le nombre maximal $N_R$ de reprogrammations possibles.

12. Dispositif de mémoire multiniveau selon la revendication 11, **caractérisé en ce que** lesdites phases de programmation/reprogrammation sont conduites dans ledit second secteur C, à compter du moment auquel une phase de reprogrammation affecte une unité de données UD dudit premier secteur S qui a atteint le nombre maximal $N_R$ de reprogrammations possibles et réciproquement, **en ce que** lesdites phases de programmation/reprogrammation sont conduites dans ledit premier secteur S à partir du moment auquel, une fois que les rôles des premier et second secteurs ont été échangés après l'effacement dudit premier secteur S, une phase de reprogrammation affecte une unité de données UD dudit second secteur C qui a atteint le nombre maximal $N_R$ des reprogrammations possibles.

13. Dispositif de mémoire multiniveau selon la revendication 11, **caractérisé en ce qu'**il effectue une phase d'effacement d'un secteur lorsque ledit second compteur d'unités purgées CUE associé audit secteur atteint le même comptage que ledit premier compteur d'unités programmées CUP.

14. Dispositif de mémoire multiniveau selon la revendication 13, **caractérisé en ce qu'**il effectue une phase de verrouillage de l'utilisation normale du dispositif de mémoire pour mettre à jour le contenu dudit second secteur C en copiant les unités de données UD qui sont encore valides depuis ledit premier secteur S, suivi par une phase d'effacement dudit premier secteur S et une phase de programmation de données dans ledit premier secteur S, ladite phase de verrouillage étant appliquée lorsqu'une unité de données UD dudit second secteur C requiert un plus grand nombre de reprogrammations que ledit nombre maximal avant ladite phase d'effacement dudit premier secteur S.

EP 1 215 679 B1

No. cells

programmed (I)

2nd reprogrammed (III)

Vth

1st reprogrammed (II)

3rd reprogrammed (IV)

ONLY FIGURE